# DEMANDE DE BREVET EUROPEEN

(11) **EP 3 996 132 A1**
(43) Date de publication de la demande: **11.05.2022**
(21) Numéro de dépôt: 21206784.7
(22) Date de dépôt: 05.11.2021
(51) Int. Cl.: H01L 21/762, H01L 21/02

(54) **PROCÉDÉ DE FORMATION D'UNE STRUCTURE DE PIÉGEAGE D'UN SUBSTRAT UTILE**

(30) Priorité: 10.11.2020 FR 2011552
(71) Demandeur: Commissariat à l'énergie atomique et aux énergies alternatives, 75015 Paris (FR)
(72) Inventeur: AUGENDRE, Emmanuel, 38054 GRENOBLE CEDEX 09 (FR); ANDRIEU, François, 38054 GRENOBLE CEDEX 09 (FR); TAILLANDIER, Cédric, 38054 GRENOBLE CEDEX 09 (FR)
(74) Mandataire: Brevalex

(57) **Abrégé**

L'invention concerne un procédé de formation d'une structure de piégeage (30) d'un substrat utile (10), et destinée à piéger des charges, et/ou limiter les diaphonies et/ou les pertes radiofréquences et/ou les distorsions d'un dispositif susceptible d'être formé sur ou dans le substrat utile (10),
le procédé étant caractérisé en ce que la formation de la structure de piégeage (30) comprend les étapes suivantes :
a) une étape de formation d'une première couche (31) qui comprend du carbure de silicium amorphe ;
b) une étape de formation d'une deuxième couche (32) en recouvrement de la première couche (31), qui comprend un matériau isolant ou semi-conducteur dans un état amorphe et qui présente une température de cristallisation inférieure à celle du carbure de silicium amorphe.

## Description

### DOMAINE TECHNIQUE

L'invention concerne le domaine des substrats pour la micro-électronique et la radiofréquence (« RF »). En particulier, la présente invention concerne le domaine des substrats de silicium sur isolant (« SOI »), et notamment pourvus d'une couche de piégeage intercalée entre un substrat support et un empilement formé d'une couche isolante et d'une couche de silicium.

La présente invention vise, à cet égard, à proposer un procédé de fabrication d'un substrat de SOI HR permettant de limiter, voire prévenir, toute dégradation du piégeage lorsque le substrat est soumis à un traitement thermique.

### ÉTAT DE LA TECHNIQUE ANTÉRIEURE

Les substrats de silicium sur isolant (« SOI » ou « Silicon On Insulator » selon la terminologie Anglo-Saxonne) sont aujourd'hui largement utilisés, et depuis de quelques années, pour la fabrication de dispositifs micro-électroniques.

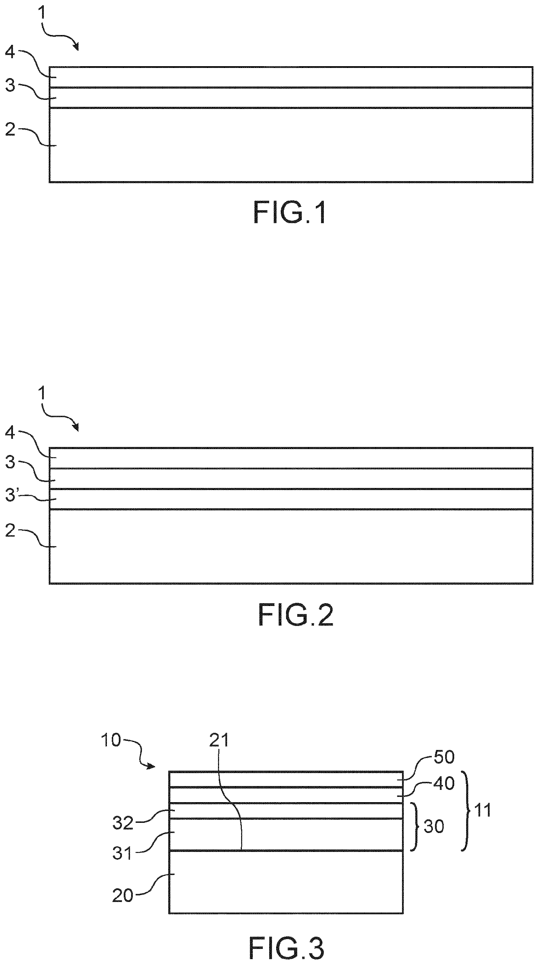

Ces substrats 1 comprennent une couche isolante 3, intercalée entre une couche de silicium 4 et un substrat support 2, destinée à isoler électriquement les composants (notamment les transistors) d'un même dispositif micro-électronique (figure 1).

Cependant dès lors qu'il s'agit de fabriquer des dispositifs radiofréquence (ci-après « RF »), par exemple pour des applications mobiles et notamment de téléphonie mobile, cette seule couche isolante ne suffit plus à assurer un fonctionnement optimal desdits dispositifs. En effet, ces derniers, lorsqu'ils fonctionnent, sont le siège de phénomènes parasites qui perturbent leur fonctionnement et affectent de facto leurs performances. Parmi les phénomènes parasites susceptibles d'être observés, les diaphonies, les non-linéarités, ou encore les courants de Foucault (« Eddy Currents » selon la terminologie Anglo-Saxonne) sont les plus courants.

Afin de répondre favorablement à ces problèmes, ou à tout le moins en limiter les effets, un nouveau type de substrat SOI, dit substrat SOI RF, a été proposé (figure 2). Ce substrat SOI RF comprend à cet égard une couche de piégeage 3' (« Trap-Rich layer » selon la terminologie Anglo-Saxonne) intercalée entre la couche isolante 3 et le substrat support 2. La couche de piégeage 3' comprend à cet égard du silicium poly-cristallin. En d'autres termes, la couche de silicium poly-cristallin comprend des grains de silicium monocristallin liés entre eux par des joints de grains.

L'efficacité de cette couche de piégeage 3' à réduire, voire à supprimer, les phénomènes parasites est intimement liée à sa densité de défauts. Plus particulièrement, plus la densité de défauts est importante, meilleure est l'efficacité de la couche de piégeage 3' à réduire les phénomènes parasites au sein d'un dispositif RF.

Il est à cet égard connu que lesdits pièges sont essentiellement localisés au niveau des joints de grains de la couche de piégeage 3'. Toutefois, les grains, lorsqu'ils sont soumis à un traitement thermique, grossissent de sorte que la densité de joints de grains s'en trouve directement affectée.

Afin de pallier ce problème, il a été proposé, tel que décrit dans le document [1] cité à la fin de la description, de disposer une couche d'oxyde, entre la couche de piégeage 3' et le substrat support 2, et destinée ralentir la croissance des grains de la couche de piégeage 3'.

Toutefois, la couche d'oxyde doit présenter une épaisseur suffisamment faible afin de permettre le franchissement et le piégeage des porteurs libres. Une faible épaisseur rend néanmoins cette couche sensible à un phénomène de dissolution lorsqu'un recuit à haute température, par exemple à 1100°C, est mis en œuvre.

De manière alternative, il a pu être considéré de disposer une couche carbonée entre la couche de piégeage 3' et le substrat support 2, afin de bloquer la croissance des grains de la couche de piégeage 3' (document [2] cité à la fin de la description).

Toutefois, même en présence de cette couche carbonée, la couche de piégeage, lorsqu'elle est soumise à un traitement thermique, voit la taille de ces grains augmenter latéralement. Cette alternative impose donc de considérer une couche de piégeage relativement fine, par exemple dont l'épaisseur est comprise entre 100 nm et 1000 nm, et par voie de conséquence limiter ses propriétés de piégeage.

Toujours de manière alternative, tel que décrit dans le document [3] cité à la fin de la description, il peut être considéré une couche de piégeage qui comprend du silicium dopé avec du carbone (la teneur atomique en carbone étant inférieure à 15 %) et reposant sur une couche inter faciale d'isolant (donc disposée entre la couche de piégeage et le substrat support). Le carbone permet ainsi de limiter la croissance latérale des grains de la couche de piégeage, tandis que la couche inter faciale limite leur croissance selon l'épaisseur de la couche de piégeage. Cette configuration n'est toutefois pas satisfaisante.

En effet, la couche inter faciale qui comprend généralement de l'oxynitrure peut contenir des charges positives qui vont attirer un surcroît d'électrons libres à l'interface (tel que rappelé dans le document [4] cité à la fin de la description).

Par ailleurs, lors d'un traitement thermique à haute température, la couche de piégeage risque de cristalliser spontanément en formant des grains d'une taille comparable à l'épaisseur de ladite couche.

Ainsi, un but de la présente invention est de proposer un procédé de formation d'une structure de piégeage dont la sensibilité aux traitements thermiques est réduite.

Un autre but de la présente invention est de proposer un procédé de formation d'une structure de piégeage permettant de limiter les perturbations susceptibles d'intervenir entre les porteurs libres et les pièges de la structure de piégeage.

Un autre but de la présente invention est de proposer un procédé de formation d'un substrat SOI HR pourvu d'une structure de piégeage dont la sensibilité aux traitements thermiques est réduite.

Un autre but de la présente invention est de proposer un procédé de fabrication d'un substrat SOI HR dans lequel d'une structure de piégeage permettant de limiter les perturbations susceptibles d'intervenir entre les porteurs libres et les pièges de la structure de piégeage.

### EXPOSÉ DE L'INVENTION

Les buts de la présente invention sont, au moins en partie, atteints par un procédé de formation d'un substrat utile comprenant une structure de piégeage, la structure de piégeage étant destinée à piéger des charges, et/ou limiter les diaphonies et/ou les pertes radiofréquences et/ou la distorsion d'un dispositif susceptible d'être formé sur ou dans le substrat utile,
le procédé comprend les étapes suivantes :
a) fourniture du substrat support ;
b) une étape de formation d'une première couche comprenant du carbure de silicium amorphe sur le substrat support ;
c) une étape de formation d'une deuxième couche en recouvrement de la première couche, la deuxième couche comprenant un matériau isolant ou semi-conducteur dans un état amorphe et qui présente une température de cristallisation inférieure à celle du carbure de silicium amorphe.

Il est prévu, dans le cadre du procédé, une étape de traitement thermique additionnelle apte à faire dégazer la première couche et la deuxième couche, et à conduire une cristallisation de la deuxième couche et de la première couche.

Selon un mode de mise en œuvre, les étapes a), b) et c) sont successives.

Avec un tel procédé, la première couche et la deuxième couche formant alors la structure de piégeage, il est possible d'obtenir une deuxième couche présentant une faible rugosité notamment au niveau de l'interface avec une couche isolante lorsque cette dernière supporte une telle couche isolante. Il est donc plus aisé d'associé une couche utile à une telle structure de piégeage contrairement à l'art antérieur qui ne présente pas une telle rugosité réduite.

Par cristallisation d'une couche, et en particulier de la première couche, on entend ici et dans le reste de ce document une cristallisation partielle ou totale de ladite couche, et en particulier de la première couche. Ainsi, une telle cristallisation permet, conformément à l'entendement généralement donné à une telle cristallisation, de couvrir à la fois une cristallisation partielle et une cristallisation totale de ladite couche.

Selon un mode de mise en œuvre, le carbure de silicium amorphe formant la première couche présente une teneur en carbone inférieure à 50 %, avantageusement comprise entre 30 % et 50 %.

Selon un mode de mise en œuvre, l'étape d) comprend également l'exécution d'un traitement thermique destiné à cristalliser exclusivement le matériau formant la deuxième couche.

Selon un mode de mise en œuvre, le traitement thermique est un recuit thermique rapide, le recuit thermique rapide comprenant une élévation de température à une température inférieure à 1100 °C, avantageusement inférieure à 1050 °C, et est d'une durée inférieure à 10 secondes, avantageusement inférieure à 1 seconde.

Selon un mode de mise en œuvre, le traitement thermique peut également être suivi d'un traitement thermique additionnel destiné à dégazer la première couche et la deuxième couche.

Selon un mode de mise en œuvre, l'étape b) et exécutée dans une chambre de dépôt chimique en phase vapeur, avantageusement dans une chambre de dépôt chimique en phase vapeur activé par plasma.

Selon un mode de mise en œuvre, l'étape c) est également exécutée dans la chambre de dépôt chimique en phase vapeur.

Selon un mode de mise en œuvre, le procédé comprenant en outre la formation, dans l'ordre et en recouvrement de la structure de piégeage, d'une couche isolante et d'une couche semi-conductrice.

Selon un mode de mise en œuvre, la formation de la couche isolante et de la couche semi-conductrice comprend un report, sur la deuxième couche, de la couche isolante et de la couche semi-conductrice à partir d'un substrat donneur.

Selon un mode de mise en œuvre, le report comprend les étapes suivantes :
1) fourniture du substrat donneur ;
2) une étape de formation de la couche isolante sur une face du substrat donneur;
3) une étape de formation d'une zone de fragilisation dans le substrat donneur qui délimite avec la couche isolante, la couche semi-conductrice ;
4) une étape d'assemblage de la couche isolante sur la deuxième couche ;
5) une étape de fracture du substrat donneur au niveau de la zone de fragilisation de manière à transférer la couche isolante et la couche semi-conductrice sur la deuxième couche.

Selon un mode de mise en œuvre, le procédé comprend en premier lieu une étape de fourniture d'un substrat de silicium sur isolant, formé d'une couche diélectrique et d'une couche utile faite d'un matériau semi-conducteur, et dans lequel le procédé comprend la formation d'une zone A2 dans laquelle la couche d'isolant et la couche de semi-conducteur sont conservées et d'une zone B2 dans laquelle la couche d'isolant et la couche de semi-conducteur du substrat de silicium sur isolant sont remplacées par du silicium monocristallin, la zone A2 et la zone B2 étant séparées par des tranchées d'isolation.

Selon un mode de mise en œuvre, la structure de piégeage est formée en recouvrement du silicium monocristallin d'au moins une zone B2.

Selon un mode de mise en œuvre, la structure de piégeage est formée dans au moins une des tranchées d'isolation en étant recouverte par le matériau isolant comblant ces dernières, de préférence la structure de piégeage est formée directement contre le substrat et définie le fond des tranchées d'isolation.

Selon un mode de mise en œuvre, le matériau formant la deuxième couche comprend au moins l'un des matériaux choisi parmi : HfO₂, Al₂O₃, Si₁₋ₓGeₓ avec x inférieur à 0,25.

Selon un mode de mise en œuvre, la première couche présente une épaisseur comprise entre 5 nm et 50 nm.

Selon un mode de mise en œuvre, la première couche présente une épaisseur comprise entre 10 nm et 50 nm.

Selon un mode de mise en œuvre, la deuxième couche présente une épaisseur comprise entre 5 nm et 15 nm.

L'invention concerne également un substrat utile pourvu d'une structure de piégeage destinée à piéger des charges, et/ou limiter les diaphonies et/ou les pertes radiofréquences et/ou la distorsion d'un dispositif susceptible d'être formé sur ou dans la structure de piégeage, le substrat utile comprend :
- un substrat support pourvu d'une face avant,
- une structure de piégeage en recouvrement de la face avant ;
- d'une couche isolante en recouvrement de la structure de piégeage ;
- une couche semi-conductrice en recouvrement de la couche isolante ;
la structure de piégeage comprenant :
- une première couche la dite première couche comprenant du carbure de silicium poly cristallin;
   et
- une deuxième couche en recouvrement de la première couche, qui comprend un matériau isolant ou semi-conducteur dans un état poly cristallin, et ledit matériau présentant, lorsqu'il est dans état amorphe une température de cristallisation inférieure à celle du carbure de silicium amorphe.

Selon un mode de mise en œuvre, un dispositif, notamment un dispositif radiofréquence, est formé sur ou dans la couche de piégeage.

Selon un mode de mise en œuvre, le carbure de silicium amorphe formant la première couche présente une teneur en carbone inférieure à 50 %, avantageusement comprise entre 30 % et 50%.

Selon un mode de mise en œuvre, la première couche présente une épaisseur comprise entre 10 nm et 30 nm.

Selon un mode de mise en œuvre, la deuxième couche présente une épaisseur comprise entre 5 nm et 15 nm.

### BRÈVE DESCRIPTION DES DESSINS

D'autres caractéristiques et avantages apparaîtront dans la description qui va suivre d'un procédé d'une structure de piégeage selon l'invention, donnés à titre d'exemples non limitatifs, en référence aux dessins annexés dans lesquels :
- la figure 1 est une représentation schématique d'un substrat SOI connu de l'état de la technique et dépourvu de couche de piégeage, le substrat SOI est notamment représenté selon un plan de coupe perpendiculaire à une face principale du dudit substrat SOI ;
- la figure 2 est une représentation schématique d'un substrat SOI RF connu de l'état de la technique et pourvu d'une couche de piégeage intercalée entre la couche d'isolant et le substrat support, le substrat SOI RF est notamment représenté selon un plan de coupe perpendiculaire à une face principale du dudit substrat SOI ;
- la figure 3 est une représentation d'un substrat utile selon la présente invention, le substrat utile est notamment représenté selon un plan de coupe perpendiculaire à la face avant du substrat support ;
- la figure 4 est une représentation schématique des étapes a) et b) de formation d'une première couche sur une face avant d'un substrat support selon la présente invention, le substrat support est notamment représenté selon un plan de coupe perpendiculaire à une face avant du substrat support ;
- la figure 5 est une représentation schématique d'une étape c) de formation d'une deuxième couche en recouvrement de la première couche selon la présente invention, le substrat support est notamment représenté selon un plan de coupe perpendiculaire à une face avant du substrat support ;
- la figure 6 est une représentation schématique d'une étape 2) de formation d'une couche d'isolant sur une face principale d'un substrat donneur, selon la présente invention, le substrat donneur est notamment représenté selon un plan de coupe perpendiculaire à une face principale du substrat support ;
- la figure 7 est une représentation schématique d'une étape 3) de formation d'une zone de fragilisation, notamment par implantation d'espèces, dans le substrat donneur afin de délimiter la couche de semi-conducteur dans ledit substrat donneur selon la présente invention, le substrat donneur est notamment représenté selon un plan de coupe perpendiculaire à une face principale du substrat donneur;
- la figure 8 est une représentation schématique d'une étape 4) d'assemblage selon la présente invention, le substrat donneur est notamment représenté selon un plan de coupe perpendiculaire à une face principale du substrat donneur ;
- la figure 9 est une représentation schématique d'une étape 5) de fracture selon la présente invention, le substrat support est notamment représenté selon un plan de coupe perpendiculaire à une face avant du substrat support ;
- la figure 10 est une représentation schématique d'un substrat utile mis en œuvre pour de l'hybridation et notamment la formation de zones A de SOI HR, et de zones B de silicium massif;
- la figure 11 est une représentation d'un deuxième exemple de mise en œuvre de formation de la structure de piégeage selon la présente invention ;
- la figure 12 est une représentation d'un troisième exemple de mise en œuvre de formation de la structure de piégeage selon la présente invention,
- la figure 13 est une représentation d'un quatrième exemple de mis en œuvre de formation de la structure de piégeage selon la présente invention.

### EXPOSÉ DÉTAILLÉ DE MODES DE RÉALISATION PARTICULIERS

La présente invention concerne un procédé de formation d'une structure de piégeage d'un substrat utile, et destinée à piéger des charges, et/ou limiter les diaphonies et/ou les pertes radiofréquences d'un dispositif susceptible d'être formé sur ou dans le substrat utile.

La formation de la structure de piégeage peut notamment comprendre les étapes suivantes :
a) fourniture du substrat utile ;
b) une étape de formation d'une première couche comprenant du carbure de silicium amorphe sur le substrat utile ;
c) une étape de formation d'une deuxième couche en recouvrement de la première couche, qui comprend un matériau isolant ou semi-conducteur dans un état amorphe et qui présente une température de cristallisation inférieure à celle du carbure de silicium amorphe.

Selon une possibilité, non comprise dans l'invention, los de l'étape de formation de la deuxième couche, le matériau isolant ou semi-conducteur peut être dans un état polycristalin.

En particulier, le procédé selon la présente invention s'attache à la problématique de formation d'une structure de piégeage qui conserve ses propriétés de piégeage lorsqu'elle est soumise à des traitements thermiques significatifs, et notamment pouvant être exécutés à des températures de l'ordre de 1000 °C, voire 1100 °C.

Cette structure de piégeage peut avantageusement être mise en œuvre dans le cadre de la formation d'un substrat utile du type semi-conducteur sur isolant, par exemple pour des applications radiofréquence (ci-après « RF »). Dans ce cas de figure, le substrat utile comprend un substrat support sur une face duquel, dite face avant, est formé un empilement de couches pourvu, à partir de la face avant, de la structure de piégeage, d'une couche isolante et d'une couche semi-conductrice.

Sur les figures 3 à 9, on peut voir un premier exemple de mise en œuvre du procédé de formation de la structure de piégeage pour la fabrication d'un substrat utile 10 du type semi-conducteur sur isolant selon l'invention.

Notamment, tel qu'illustré à la figure 3, le substrat utile 10 comprend un substrat support 20 sur une face duquel, dite face avant 21, est formé un empilement 11 de couches qui comprend, à partir de la face avant 21, une structure de piégeage 30, une couche isolante 40 et une couche semi-conductrice 50.

La structure de piégeage 30 comprend notamment, à partir de la face avant 21, une première couche 31 et une deuxième couche 32 en recouvrement de la première couche 31.

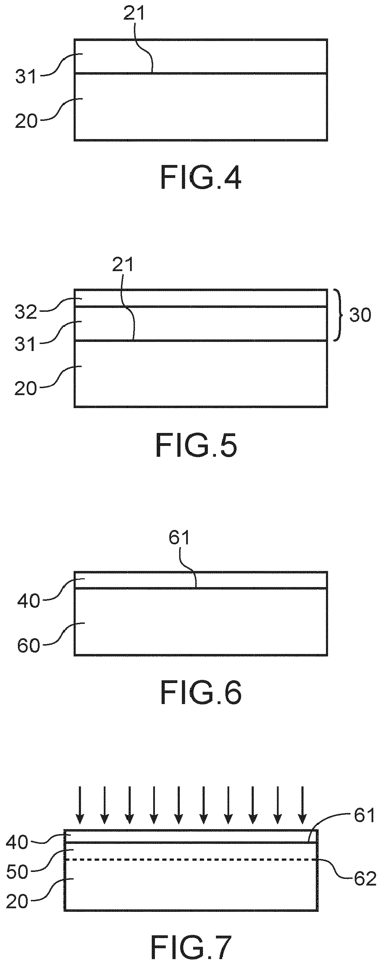

Le procédé comprend notamment, tel qu'illustré à la figure 4, une étape a) de fourniture d'un substrat support 20.

Le substrat support 20 peut par exemple comprendre du silicium, et plus particulièrement du silicium, dit haute résistivité, qui présente une résistivité supérieure à 1 kOhm.cm.

L'invention n'est toutefois pas limitée à la seule mise en œuvre du silicium, et l'homme du métier pourra, sur la base de ses connaissances générales et de la description qui suit, considérer toute autre type de matériau. A titre d'exemple, le substrat support 20 peut comprendre au moins des matériaux choisis parmi : verre, quartz, une céramique.

Le procédé comprend également une étape b) de formation d'une première couche 31 sur une face avant 21 d'un substrat support 20 (figure 4).

La formation de la première couche 31 peut être précédée d'une étape de nettoyage de la face avant 21 avant de retirer toute trace de contaminant.

Par ailleurs, la première couche 31, selon la présente invention, comprend du carbure de silicium, et avantageusement avec une teneur atomique en carbone inférieure à 50 % (il est entendu que la teneur atomique en carbone est strictement supérieure à 0 %), avantageusement comprise entre 30 % et 50 %.

La formation de cette première couche 31 peut impliquer un dépôt chimique en phase vapeur, et plus particulièrement un dépôt chimique en phase vapeur assisté par plasma. La température de dépôt peut être comprise entre 320°C et 480°C, par exemple égale à 350 °C.

La première couche 31 peut par ailleurs présenter une épaisseur comprise entre 5 nm et 50 nm.

L'étape b) est suivie d'une étape c) de formation d'une deuxième couche 32 en recouvrement de la première couche 31 (illustré à la figure 5).

Cette deuxième couche 32 comprend notamment un matériau isolant ou semi-conducteur dans un état amorphe, et qui présente une température de cristallisation inférieure à celle du carbure de silicium amorphe.

A titre d'exemple, le matériau formant la deuxième couche 32 peut comprendre au moins l'un des matériaux choisi parmi : HfO₂, Al₂O₃, Si₁₋ₓGeₓ avec x inférieur à 0,25, ou encore du silicium amorphe.

Par ailleurs, la deuxième couche 32 peut présenter une épaisseur comprise entre 5 nm et 15 nm.

La formation de la deuxième couche 32 peut comprendre un dépôt chimique en phase vapeur, par exemple un dépôt chimique en phase vapeur assisté par plasma.

De manière particulièrement avantageuse, la formation de la première couche 31 et de la deuxième couche 32 sont exécutées dans la même chambre de dépôt sans remise à l'air de cette dernière. Un tel enchainement permet de protéger la première couche 31 de l'humidité à l'issue de l'étape b).

L'invention n'est pas limitée à cette seule technique de dépôt et peut de manière alternative comprendre un dépôt chimique en phase vapeur d'un précurseur organométallique, ou un dépôt en couches atomiques.

Le procédé peut également comprendre une étape d) qui comprend l'exécution d'un traitement thermique destiné à cristalliser exclusivement le matériau formant la deuxième couche 32. La taille des grains formés lors de la cristallisation est par ailleurs limitée à l'épaisseur de la deuxième couche 32. Ainsi, la considération d'une deuxième couche fine, par exemple dont l'épaisseur est comprise entre 5 nm et 15 nm, permet d'imposer aux dits grains une taille comprise également dans cette gamme.

Le traitement thermique peut à cet égard comprendre un recuit thermique rapide qui comprend une élévation de température à une température inférieure à 1100 °C, voire inférieure à 1050 °C, et est d'une durée inférieure à 10 secondes, de préférence inférieure à 1 secondes.

Ce traitement thermique peut également être suivi d'un traitement thermique additionnel destiné à dégazer la première couche 31 et la deuxième couche 32. Ce traitement thermique additionnel, en vue du dégazage des couches 31 et 32, conduit également à la cristallisation de la première couche 31. La considération de la deuxième couche 32, cristallisée lors du traitement thermique, permet de limiter la taille des grains formés lors de la cristallisation de la première couche 32 lors de ce traitement thermique additionnel. En particulier, les grains de la deuxième couche 32 servent de germes lors de la cristallisation.

Une teneur atomique en carbone élevée, et notamment comprise entre 30 % et 50 %, permet d'augmenter le budget thermique nécessaire à la cristallisation du carbure de silicium, mais contribue également à ralentir cette dernière. Ainsi, la combinaison d'une teneur élevée en carbone et de la deuxième couche selon les termes de la présente invention, permet de limiter la taille des grains de la première couche, et de figer leur structure lors de traitements thermiques ultérieurs susceptibles d'intervenir.

Le procédé selon la présente invention peut également comprendre un report, sur la deuxième couche 32, de la couche isolante 40 et de la couche semi-conductrice 50 à partir d'un substrat donneur 60.

Le report peut comprendre une étape 1) de fourniture d'un substrat donneur 60.

Le substrat donneur 60 peut par exemple comprendre du silicium, et notamment du silicium monocristallin. La couche isolante 40 peut comprendre du dioxyde de silicium et présenter une épaisseur comprise entre 10 nm et 1000 nm.

Le report comprend également une étape 2) de formation de la couche isolante 40 sur une face, dite face principale 61, du substrat donneur 60 (figure 6).

La couche isolante 40 peut être formée lors d'une étape de dépôt, ou tout simplement être le résultat d'une étape d'oxydation thermique du substrat donneur 60 en silicium.

L'étape 2) est suivie d'une étape 3) de formation d'une zone de fragilisation 62 dans le substrat donneur 60 qui délimite, avec la couche isolante 40, la couche de semi-conducteur 30 (figure 7). En d'autres termes, la couche de semi-conducteur 50 s'étend à partir de la face principal 61 du substrat donneur 60 et selon une épaisseur déterminée par le positionnement de la zone de fragilisation 62.

La formation de la zone de fragilisation 62 peut comprendre une étape d'implantation d'espèces, et notamment d'ions légers tels que des ions hydrogène et/ou des ions hélium. La dose d'espèces implantées peut par exemple être supérieure à 10¹⁶ atomes/cm².

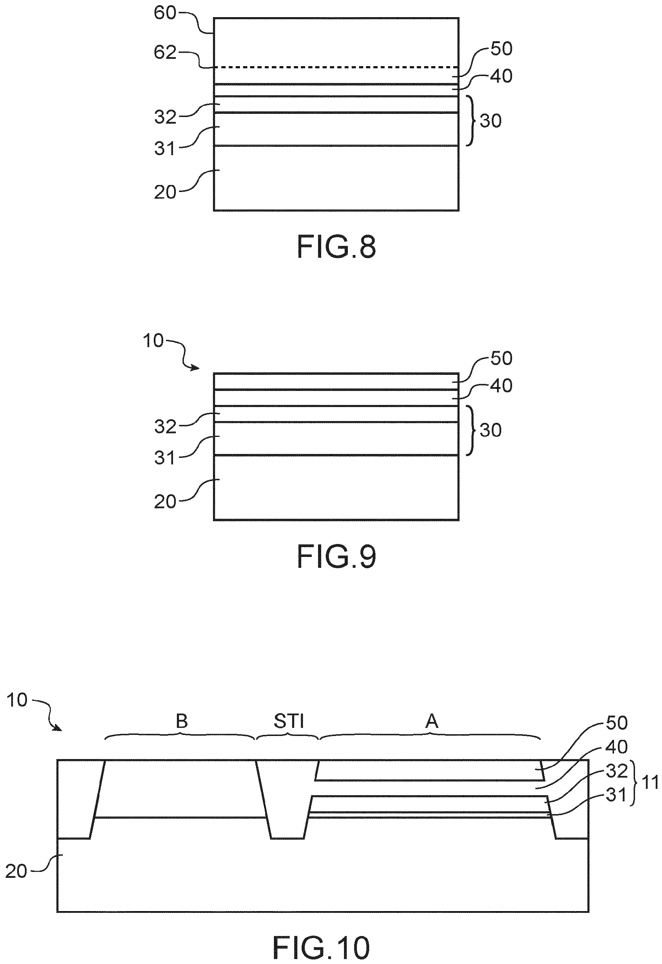

Le procédé peut également comprendre une étape 4) d'assemblage de la couche isolante 40 avec la deuxième couche 32 (figure 8).

L'étape d'assemblage peut par exemple comprendre un collage moléculaire par mise en contact de la couche isolante 40 et de la deuxième couche 32.

Enfin, l'étape 4) peut être suivie d'une étape 5) de fracture du substrat donneur au niveau de la zone de fragilisation 62 de manière à transférer la couche isolante 40 et la couche semi-conductrice 50 sur la deuxième couche 32 (figure 9).

Des étapes de finition, telles que des polissages et/ou des traitements thermiques peuvent être également considérés pour renforcer l'interface d'assemblage et/ou lisser la face exposée à l'environnement extérieur de la couche de semi-conducteur 50.

Le procédé selon la présente invention permet ainsi de former un substrat utile 10 du type semi-conducteur sur isolant et qui comprend une structure de piégeage formée de la première couche 31 et de la deuxième couche 32.

En particulier, dans la présente invention, la première couche 31 comprend du carbure de silicium, avec notamment un teneur atomique en carbure comprise entre 30 % et 50 %. Les atomes de carbone contenus dans la première couche 31 sont autant de sites de piégeage qui renforcent les capacités de piégeage de la structure de piégeage 30. Ces derniers limitent également la cristallisation de la première couche 31.

La considération de la deuxième couche 32, faite d'un matériau qui présente une température de cristallisation inférieure à celle du carbure de silicium amorphe, permet de cristalliser ladite deuxième couche avant la première couche 31. Dans la mesure où cette couche peut être fine, les grains formés lors de la cristallisation de cette dernière restent petits (d'une taille inférieure à l'épaisseur de la deuxième couche), et servent de germe à une cristallisation du carbure de silicium de la première couche susceptible d'intervenir lors d'un recuit thermique. En d'autres termes la taille des grains de carbure de silicium susceptibles d'être formés est régie par celle des grains du matériau formant la première couche.

Le substrat utile 10 ainsi obtenu peut de manière avantageuse comprendre une deuxième couche 32 faite de silicium poly cristallin, et une couche d'isolant 40 relativement fine, par exemple comprise entre 2 nm et 25 nm.

Cette configuration connue sous la dénomination de SOI UTBB (pour substrat SOI avec une couche d'oxyde enterré ultra fin), est également associée à une couche de semi-conducteur 50 relativement fine (figure 10).

Un tel substrat SOI UTBB peut avantageusement être mis en œuvre pour co-intégrer des dispositifs RF avec des dispositifs logiques par exemple. A cet égard, cette co-intégration peut impliquer la formation de zones « B » au niveau desquelles l'empilement 11 est remplacé par du silicium monocristallin tout en conservant l'empilement 11 au niveau de zones « A ». Par ailleurs les zones « A » et « B » sont avantageusement séparées les unes des autres de tranchées d'isolation STI.

La formation des zones « B » peut impliquer en premier lieu la réalisation des tranchées d'isolation STI, puis la gravure de l'empilement 11 et enfin une croissance de silicium monocristallin (croissance épitaxiale).

La considération d'épaisseurs de couches relativement faibles facilite l'étape de gravure pour la création des zones hybrides « B ».

Avantageusement, la deuxième couche 32, qui comprend des grains de petite taille, permet un contrôle de la variabilité de la tension de seuil associée à la grille arrière d'un transistor susceptible d'être formé sur ou dans la couche de semi-conducteur 50.

En outre, la profondeur des tranchées d'isolation STI qui est supérieure à l'épaisseur totale de l'empilement 11 permet ainsi de réduire les chemins de fuite entre les zones « A ».

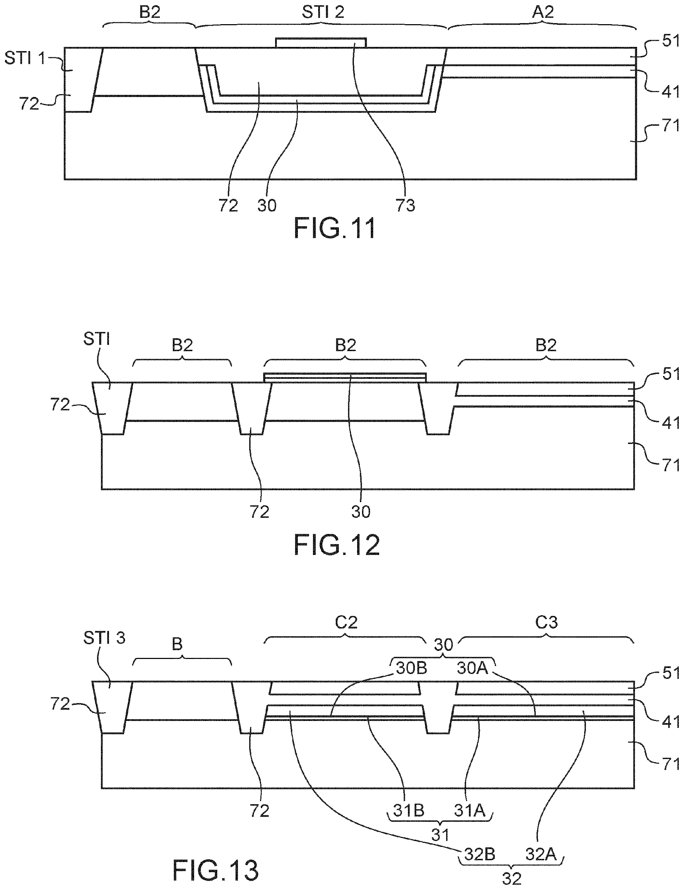

A la figure 11, on peut voir un deuxième exemple de mise en œuvre de formation de la structure de piégeage 30 à partir d'un substrat de silicium sur isolant 70.

Le substrat de silicium sur isolant 70 comprend notamment un substrat de silicium 71, et en recouvrement d'une face principale de ce substrat, une deuxième couche d'isolant 41 et une deuxième couche de semi-conducteur 51.

Cet exemple comprend la formation de premières tranchées STI 1 et de deuxièmes tranchées STI 2 sur un substrat de silicium sur isolant 70. Cette formation comprend notamment une gravure de la deuxième couche d'isolant 41 et de la deuxième couche de semi-conducteur 51. Les tranchées STI 1 et STI 2 sont, dans cet exemple, comblées par un matériau isolant 72, par exemple par du dioxyde de silicium. Toutefois, les deuxièmes tranchées STI 2 comprennent également la structure de piégeage 30 intercalée entre d'une part le fond et éventuellement les parois de ladite tranchée, et d'autre part le matériau isolant 72. En d'autres termes, la structure de piégeage 30 est formée avant le matériau isolant 72.

Les détails relatifs à la formation des tranchées STI 1 et STI 2 sont connus de l'homme du métier et ne sont par conséquent par présentés dans la présente demande.

En outre, la structure de piégeage 30 est formée de manière à ne pas présenter de section exposée à l'environnement extérieur. En d'autres termes, la formation de la structure de piégeage peut impliquer une gravure de cette dernière au niveau des parois des deuxièmes tranchées STI 2.

Ce deuxième mode de mise en œuvre peut également comprendre la considération de zones A2 et de zones B2. Les zones A2 sont à cet égard des zones au niveau desquelles la deuxième couche d'isolant 41 et la deuxième couche de semi-conducteur 51 sont conservées, tandis que ces deux couches 41 et 51 sont remplacées par du silicium monocristallin au niveau des deuxièmes zones B2.

Les STI 2 sont alors avantageusement mise en œuvre pour la formation de composants passifs 73, tels que des inductances.

La figure 12 illustre un troisième exemple de formation de la structure de piégeage 30.

A l'instar du deuxième mode de réalisation, le substrat de silicium sur isolant 70 est également considéré.

Ce troisième mode de réalisation comprend la formation des premières tranchées STI 1, et des zones hybrides B2 tout en conservant les zones A2 décrites précédemment.

Dans cet exemple la structure de piégeage 30 est formée en recouvrement de zones hybrides B2.

Les différents modes de réalisation de la présente invention mettent en œuvre une structure de piégeage qui présente une sensibilité réduite aux traitements thermiques.

Cette dernière ne met pas non plus en œuvre de couche inter faciale susceptible de perturber les interactions entre les porteurs libres et les pièges de la structure de piégeage.

Il est entendu que chacun mode de réalisation considéré dans la présente invention peuvent reprendre des éléments, dans la mesure où ces derniers sont compatibles, des autres modes de réalisation présentés.

La figure 13 illustre un substrat utile selon un quatrième exemple de mise en œuvre formation de la structure de piégeage selon la présente invention.

Dans le cadre du présent exemple, la deuxième couche 32 présente une première région 32A et une deuxième région 32B se distinguant l'une de l'autre par une concentration respective en éléments dopants dudit deuxième matériau. Ainsi, par exemple, la première région 32A peut présenter une concentration en éléments dopants du type non intentionnellement dopé, la deuxième région 32B présentant, du fait par semple d'une étape d'implantation localisée d'éléments dopant, une concentration en éléments dopants du type intentionnellement dopé. Selon cet exemple, la deuxième région 32B de la deuxième couche 32 présente alors une concentration en éléments dopants supérieure à celle de la première région 32B de la deuxième couche 32.

Bien entendu, il est également envisageable, sans que l'on sorte du cadre de l'invention, que la première et la deuxième région 32A, 32B de la deuxième couche 32 soit toutes deux d'un type intentionnellement dopée, celles-ci se distinguant l'une de l'autre par une concentration respective en éléments dopants. Ainsi, la deuxième région 32B peut présenter une concentration en éléments dopants du même type que celle de la première région 32A de la deuxième couche 32, par exemple un dopage du type N (ou P), avec une concentration supérieure en lesdits éléments dopants, ou encore présenter une concentration en éléments dopants d'un type distinct de celle de la première région 32A de la deuxième couche 32, la première région 32A présentant par exemple un dopage du type N et la deuxième région 32B présentant par exemple un dopage du type P.

Une telle présence d'une première région 32A et d'une deuxième région 32B présentant des configurations en éléments dopant différentes l'une de l'autre (cette différence pouvant être lié au type de conductivité, les conductivités pouvant être opposées, ou être pour l'une, d'un type parmi un dopage N et P, et pour l'autre d'un type de conductivité du type dopage intrinsèque, ou lié à des concentrations distinctes les unes des autres), permet à la deuxième couche 32 de fournir différentes fonction. Ainsi par exemple, la deuxième couche 32 peut fournir, par l'intermédiaire de l'une de ces régions 32A, 32B, une fonction de grille arrière pour des transistors à effet de champs réalisés dans la deuxième couche de semi-conducteur 51, et, par l'intermédiaire de l'autre région 32A, 32B, une fonction de zone de piégeage pour des composants exempt de grille arrière.

Comme illustré sur la figure 13, dans ce quatrième exemple, la première région 32A de la deuxième couche 32 forme avec une région 31A correspondante de la première couche 31 une sous-structure de piégeage 30A. De même, la deuxième région 32B de la deuxième couche 32 forme avec une région 31B correspondante de la première couche 31 une deuxième sous-structure de piégeage 30B. La première sous-structure de piégeage 30A de la deuxième sous-structure de piégeage 30B sont séparées l'une de l'autre par une tranchée d'isolation STI 3 remplie d'un matériau isolant 72.

On notera que chacune de ces sous-structures de piégeage sont associées avec une deuxième couche d'isolant 41 et la deuxième couche de semi-conducteur 51 qui leur est respectives. De cette manière, il est formé deux zones C2, C3 distinctes du substrat utile, l'une C3 associée à la première sous-structure de piégeage 30A et l'autre C2 associée à la deuxième sous-structure de piégeage 30B.

Selon une possibilité de ce quatrième mode de réalisation, d'une manière identique aux premier, deuxième et troisième exemples de mise en œuvre formation de la structure de piégeage selon la présente invention, il peut être prévu une zone B du substrat utile dans laquelle la deuxième couche d'isolant 41 et la deuxième couche de semi-conducteur sont remplacées par du silicium monocristallin. En conformité avec les premier, deuxième et troisième exemples de mise en œuvre, ladite zone B est séparée des deux zones C2, C3 par une tranchée d'isolation STI 3 remplie d'un matériau isolant 72.

Un tel substrat utile peut être réalisé par la mise en œuvre d'un procédé de réalisation selon l'invention pour lequel :
- lors de l'étape d) de formation de la deuxième couche 32 en recouvrement de la première couche 31, le deuxième matériau est un semiconducteur amorphe, ladite deuxième couche 32 présentant une première région 32A et une deuxième région 32B se distinguant l'une de l'autre par une concentration respective en éléments dopants dudit deuxième matériau ;
- il est en prévu la formation d'au moins une tranchée d'isolation STI 3 remplie d'un matériau isolant afin de séparer la première sous-structure de piégeage 30A de la deuxième sous-structure de piégeage 30B.

On notera que dans le cadre du procédé, l'étape d) de formation de la deuxième couche 32 peut comprendre une étape d'implantation localisée d'au moins une de la première et la deuxième région 32A, 32B de la deuxième couche 32 afin de permettre la fourniture de la première région 32A et la deuxième région 32B avec une concentration respective en éléments dopants.

Selon la possibilité où il est prévu une zone B du substrat utile dans laquelle la deuxième couche d'isolant 41 et la deuxième couche de semi-conducteur sont remplacées par du silicium monocristallin, le procédé peut comporter une étape ultérieure comprenant les sous-étapes suivantes :
- retrait de la première couche 31 et de la deuxième couche 32 sur une partie du substrat support 20;
- la formation d'une couche semiconductrice recouvrant au moins partiellement la partie du substrat support sur laquelle la première couche et de la deuxième couche ont été retirées.

### RÉFÉRENCES

[1] WO 2012/127006 ;
[2] WO 2017/144821 ;
[3] US 2016/0071959 ;
[4] Yoshimo Miura et al., "Paramagnetic Defects Related to Positive Charges in Silicon Oxynitride Films", Jpn. J. Appl. Phys., Vol. 39, pp. L 987-L989, (2000).

## Revendications

1. Procédé de formation d'un substrat utile (10) comprenant une structure de piégeage (30), la structure de piégeage étant destinée à piéger des charges, et/ou limiter les diaphonies et/ou les pertes radiofréquences et/ou la distorsion d'un dispositif susceptible d'être formé sur ou dans le substrat utile (10),
le procédé comprend les étapes suivantes :
a) fourniture du substrat support (20) ;
b) une étape de formation d'une première couche (31) comprenant du carbure de silicium amorphe sur le substrat support (20) ;
c) une étape de formation d'une deuxième couche (32) en recouvrement de la première couche (31), la deuxième couche (32) comprenant un matériau isolant ou semi-conducteur dans un état amorphe et qui présente une température de cristallisation inférieure à celle du carbure de silicium amorphe,
dans lequel il est prévu une étape de traitement thermique additionnel apte à dégazer la première couche (31) et la deuxième couche (32), et à conduire une cristallisation de la deuxième couche (32) et de la première couche (31).

2. Procédé de formation d'un substrat utile (10) selon la revendication 1, dans lequel le carbure de silicium amorphe formant la première couche (31) présente une teneur en carbone inférieure à 50 %, avantageusement comprise entre 30% et 50%.

3. Procédé de formation d'un substrat utile (10) selon l'une des revendications 1 à 2, dans lequel l'étape b) est exécutée dans une chambre de dépôt chimique en phase vapeur, avantageusement dans une chambre de dépôt chimique en phase vapeur activé par plasma.

4. Procédé de formation d'un substrat utile (10) selon l'une des revendications 1 à 3, le procédé comprenant en outre la formation, dans l'ordre et en recouvrement de la structure de piégeage (30), d'une couche isolante (40) et d'une couche semi-conductrice (50).

5. Procédé de formation d'un substrat utile (10) selon la revendication 4, dans lequel la formation de la couche isolante (40) et de la couche semi-conductrice (50) comprend un report, sur la deuxième couche (32), de la couche isolante (40) et de la couche semi-conductrice (50) à partir d'un substrat donneur (60).

6. Procédé de formation d'un substrat utile (10) selon la revendication 5, dans lequel le report comprend les étapes suivantes :
1) fourniture du substrat donneur (60) ;
2) une étape de formation de la couche isolante (40) sur une face du substrat donneur (60) ;
3) une étape de formation d'une zone de fragilisation (62) dans le substrat donneur (60) qui délimite avec la couche isolante (40), la couche semi-conductrice (50) ;
4) une étape d'assemblage de la couche isolante (40) sur la deuxième couche (32);
5) une étape de fracture du substrat donneur (60) au niveau de la zone de fragilisation (62) de manière à transférer la couche isolante (40) et la couche semi-conductrice (50) sur la deuxième couche (32).

7. Procédé de formation d'un substrat utile (10) selon l'une quelconque revendication 1 à 6, dans lequel la structure de piégeage (30) est formée dans au moins une tranchée d'isolation en étant recouverte par un matériau isolant (72) comblant cette dernière, de préférence la structure de piégeage (30) est formée directement contre le substrat et définie le fond de l'au moins une tranchée d'isolation (STI 2).

8. Procédé de formation d'un substrat utile (10) selon l'une quelconque des revendications 1 à 6, dans lequel lors de l'étape c) de formation de la deuxième couche (32) en recouvrement de la première couche (31), le deuxième matériau est un semiconducteur amorphe, ladite deuxième couche (32) présentant une première région (32A) et une deuxième région (32B) se distinguant l'une de l'autre par une concentration respective différente en éléments dopants dudit deuxième matériau.

9. Procédé de formation d'un substrat utile (10) selon la revendication 8, dans lequel la première région (32A) présente une concentration en éléments dopants du type non-intentionnellement dopé.

10. Procédé de formation d'un substrat utile (10) selon la revendication 8 ou 9, dans laquelle la première région (32A) de la deuxième couche (32) forme avec une région (31A) correspondante de la première couche (31) une sous-structure de piégeage (30A), la deuxième région (32B) de la deuxième couche (32) formant avec une région (31B) correspondante de la première couche (31) une deuxième sous-structure de piégeage (30B),
dans lequel il est en outre prévu la formation d'au moins une tranchée d'isolation (STI 3) remplie d'un matériau isolant afin de séparer la première sous-structure de piégeage (30A) de la deuxième sous-structure de piégeage (30B).

11. Procédé de formation d'un substrat utile (10) selon l'une quelconque des revendications 8 à 10, dans lequel il est prévu une étape ultérieure comprenant les sous-étapes suivantes :
- retrait de la première couche (31) et de la deuxième couche (32) sur une partie du substrat support (20);
- la formation d'une couche semiconductrice recouvrant au moins partiellement la partie du substrat support sur laquelle la première couche et de la deuxième couche ont été retirées.

12. Procédé selon l'une des revendications 1 à 11, dans lequel le matériau formant la deuxième couche (32) comprend au moins l'un des matériaux choisis parmi : HfO₂, Al₂O₃, Si₁₋ₓGeₓ avec x inférieur à 0,25.

13. Procédé selon l'une des revendications 1 à 12, dans lequel la première couche (31) présente une épaisseur comprise entre 10 nm et 50 nm et/ou la deuxième couche (32) présente une épaisseur comprise entre 5 nm et 15 nm.

14. Substrat utile (10) pourvu d'une structure de piégeage (30) destinée à piéger des charges, et/ou limiter les diaphonies et/ou les pertes radiofréquences et/ou la distorsion d'un dispositif susceptible d'être formé sur ou dans la structure de piégeage (30), le substrat utile comprend :
- un substrat support (20) pourvu d'une face avant (21) ;
- une structure de piégeage (30) en recouvrement de la face avant (21) ;
- d'une couche isolante (40) en recouvrement de la structure de piégeage (30) ;
- une couche semi-conductrice (50) en recouvrement de la couche isolante (40) ; la structure de piégeage (30) comprenant :
- une première couche (31), la dite première couche (31) comprenant du carbure de silicium poly cristallin ;
et
- une deuxième couche (32) en recouvrement de la première couche (31), qui comprend un matériau isolant ou semi-conducteur dans un état poly cristallin, ledit matériau présentant, lorsqu'il est dans état amorphe une température de cristallisation inférieure à celle du carbure de silicium amorphe.

15. Substrat utile (10) selon la revendication 14, dans lequel un dispositif, notamment un dispositif radiofréquence, est formé sur ou dans la couche de piégeage.
